# EUROPÄISCHE PATENTANMELDUNG

(11) **EP 0 875 942 A2**
(43) Veröffentlichungstag der Anmeldung: **04.11.1998**
(21) Anmeldenummer: 98105421.6
(22) Anmeldetag: 25.03.1998
(51) Int. Cl.: H01L 29/78, H01L 29/08, H01L 21/336

(54) **MOS-Transistor und Verfahren zu dessen Herstellung**

(30) Priorität: 29.04.1997 DE 19718167
(71) Anmelder: SIEMENS AKTIENGESELLSCHAFT, 80333 München (DE)
(72) Erfinder: Biebl, Markus, Dr., 86163 Augsburg (DE); Schäfer, Herbert, Dr., 85635 Höhenkirchen-Siegertsbrunn (DE)

(57) **Zusammenfassung**

Ein in einem Halbleitersubstrat (1) integrierter MOS-Transistor weist an der Oberfläche seiner Source-/Draingebiete (10) epitaktisch gewachsene, dotierte Polysiliziumstrukturen (8) auf, die als Diffusionsquelle für die Herstellung der Source-/Draingebiete (10) geeignet sind. Die dotierten Polysiliziumstrukturen (8) werden insbesondere durch selektive Epitaxie auf der durch einen vorhergehenden Trockenätzprozeß geschädigten Oberfläche des Halbleitersubstrat (1) gebildet. Durch Ausdiffusion werden die Source-/Draingebiete (10) mit geringer Tiefe hergestellt.

## Beschreibung

Bei der Miniaturisierung der Bauelemente im Hinblick auf eine erhöhte Packungsdichte werden sowohl laterale als auch vertikale Dimensionen reduziert. Bei MOS-Transistoren bedeutet dies, daß nicht nur die lateralen Abmessungen der Gateelektrode und die Kanallänge sondern auch die Tiefe der Source-/Draingebiete reduziert wird.

Bei der Herstellung flacher Source-/Draingebiete durch Implantation ist aufgrund der Reichweite der Ionen im Kristall und der verfügbaren Energien bei der Ionenimplantation bei einer Tiefe von etwa 100 nm eine Grenze erreicht. Flachere Source-/Draingebiete können durch Diffusion gebildet werden.

In EP 0 268 941 B1 ist eine MOS-Transistorstruktur mit flachen Source-/Drainzonen vorgeschlagen worden, die zwischen Feldoxidbereichen angeordnet ist. Zwischen der Gateelektrode und den Feldoxidbereichen sind durch selektive Epitaxie erzeugte einkristalline, dotierte Siliziumschichten angeordnet. Die dotierten Siliziumschichten haben als Diffusionsquellen zur Erzeugung der Source-/Drainzonen im Substrat gedient. Ferner bilden sie die Anschlußbereiche zu darüber angeordneten, aus Silizid bestehenden Source-/Drainanschlüssen.

Zur Bildung einer einkristallinen Siliziumschicht durch selektive Epitaxie ist es erforderlich, die Oberfläche des Substrats, auf die die einkristalline Siliziumschicht selektiv aufgewachsen wird, Reinigungsprozessen zu unterziehen. Damit ist ein zusätzlicher Prozeßaufwand verbunden.

Der Erfindung liegt das Problem zugrunde einen MOS-Transistor anzugeben, der mit flachen Source-/Draingebieten und gegenüber dem bekannten reduzierten Prozeßaufwand herstellbar ist.

Ferner soll ein Herstellverfahren für diesen MOS-Transistor angegeben werden.

Die Erfindung wird erfindungsgemäß gelöst durch einen MOS-Transistor gemäß Anspruch 1 sowie durch ein Verfahren gemäß Anspruch 2. Weitere Ausgestaltungen der Erfindung gehen aus den übrigen Ansprüchen hervor.

In dem erfindungsgemäßen MOS-Transistor ist an der Oberfläche der Source-/Draingebiete jeweils eine epitaktisch gewachsene, dotierte Polysiliziumstruktur angeordnet, die von demselben Leitfähigkeitstyp wie die Source-/Draingebiete dotiert ist. Diese dotierte Polysiliziumstruktur ist als Diffusionsquelle zur Herstellung der Source-/Draingebiete geeignet. Zur Herstellung einer Polysiliziumstruktur ist eine Reinigung der darunterliegenden Substratoberfläche nicht erforderlich.

Vorzugsweise erfolgt die Herstellung der dotierten Polysiliziumstruktur durch selektive Epitaxie. Dabei wird an einer Oberfläche eines Halbleitersubstrats, zum Beispiel einer monokristallinen Siliziumscheibe oder der monokristallinen Siliziumschicht eines SOI-Substrates, ein Gatedielektrikum und eine Gateelektrode gebildet. Eine isolierende Schicht mit im wesentlichen konformer Kantenbedeckung wird abgeschieden. Sie überdeckt die Gateelektrode vollständig. Durch anisotropes Rückätzen der isolierenden Schicht werden an den Seitenwänden der Gateelektrode Spacer gebildet. Bei der Spacerbildung wird die Oberfläche des Halbleitersubstrats freigelegt und geschädigt. Auf dieser geschädigten Oberfläche werden anschließend durch selektive Epitaxie die dotierten Polysiliziumstrukturen erzeugt. Dabei wird ausgenutzt, daß bei der selektiven Epitaxie auf einer geschädigten, nicht vorgereinigten Oberfläche eines Halbleitersubstrats das Halbleitermaterial polykristallin aufwächst.

Die Source-/Draingebiete werden anschließend durch Ausdiffusion aus den dotierten Polysiliziumstrukturen gebildet. Da die Dotierstoffdiffusion in Polysilizium um einige Größenordnungen schneller erfolgt als im einkristallinen Silizium, sind die dotierten Polysiliziumstrukturen nahezu ideale Festkörperdiffusionsquellen. Das heißt, die Dotierstoffkonzentration an der Grenzfläche zwischen der Polysiliziumstruktur und dem Halbleitersubstrat ist im wesentlichen konstant. Dadurch ist die Tiefe der Source-/Draingebiete bei der Ausdiffusion sehr reproduzierbar einstellbar. Es lassen sich dadurch flache Source-/Draingebiete mit einer Tiefe zwischen 10 und 200 nm herstellen.

Es liegt im Rahmen der Erfindung, nach der selektiven Epitaxie eine thermische Oxidation durchzuführen. Dabei werden eventuell bei der selektiven Epitaxie gebildete Spalte zwischen den dotierten Polysiliziumstrukturen und den Spacern an den Seitenwänden der Gatelektrode aufgefüllt. Ferner bildet sich eine Siliziumoxidschicht an der Oberfläche der dotierten Polysiliziumstrukturen.

Es liegt im Rahmen der Erfindung, die dotierten Polysiliziumstrukturen durch eine Implantation zu dotierten. Da die Diffusion im Polysilizium im Vergleich zu Silizium schnell ist, braucht diese Implantation nicht bis in den Bereich der Grenzfläche zum Halbleitersubstrat zu erfolgen. Dadurch wird eine Schädigung des Halbleitersubstrats im Gebiet der Source-/Draingebiete vermieden. Bei der Implantation wird die durch thermische Oxidation gebildete Siliziumoxidschicht vorzugsweise als Streuoxid verwendet.

Es liegt im Rahmen der Erfindung, in der Oberfläche des Halbleitersubstrats zunächst eine Isolationsstruktur zu bilden, die ein aktives Gebiet für den MOS-Transistor definiert. Die Gateelektrode wird anschließend so strukturiert, daß sie streifenförmig über dem aktiven Gebiet verläuft und das aktive Gebiet in zwei Teilgebiete unterteilt. Bei der selektiven Epitaxie zur Bildung der dotierten Polysiliziumstrukturen wachsen diese selbstjustiert an der Oberfläche der beiden Teilgebiete auf. Daher ist eine weitere Strukturierung zur lateralen Definition der Source-/Draingebiete nicht erforderlich.

Zur Bildung der Spacer an den Seitenwänden der Gateelektrode wird ein anisotroper Trockenätzprozeß verwendet, zum Beispiel CHF₃/CF₄.

Die selektive Epitaxie wird unter Verwendung eines H₂, HCl, SiH₂Cl₂ enthaltenden Prozeßgases im Temperaturbereich zwischen 700°C und 900°C und im Druckbereich zwischen 1 und 700 Torr durchgeführt.

Das Verfahren ist sowohl zur Herstellung von n-Kanal-Transistoren als auch zur Herstellung von p-Kanal-Transistoren geeignet. Darüber hinaus können mit dem erfindungsgemäßen Verfahren CMOS-Schaltungen hergestellt werden. Dazu werden die dotierten Polysiliziumstrukturen für die n-Kanal-Transistoren anders dotiert als die dotierten Polysiliziumstrukturen für die p-Kanal-Transistoren. Bei der Implantation zur Dotierung der von einem ersten Leitfähigkeitstyp dotierten Polysiliziumstrukturen werden die übrigen mit einer Photolackmaske abgedeckt. Anschließend werden die von einem zweiten, dazu entgegengesetzten Leitfähigkeitstyp dotierten Polysiliziumstrukturen implantiert. Dabei wird eine weitere Photolackmaske verwendet. Die Ausdiffusion aus den dotierten Polysiliziumschichten zur Bildung der Source-/Draingebiete kann in einem gemeinsamen Temperschritt erfolgen. Alternativ kann zwischen den Implantationsschritten eine zusätzliche Temperung durchgeführt werden, um einen langsamer diffundierenden Dotierstoff entsprechend tief einzutreiben.

Im folgenden wird die Erfindung anhand eines Ausführungsbeispiels, das in den Figuren dargestellt ist, näher erläutert.
- Figur 1: zeigt einen Schnitt durch ein Substrat mit einer Isolationsstruktur, die ein aktives Gebiet definiert.
- Figur 2: zeigt einen Schnitt durch das Substrat nach Bildung eines Gatedielektrikums und Strukturierung einer Gateelektrode.
- Figur 3: zeigt einen Schnitt durch das Substrat nach Bildung von Spacern an den Seitenwänden der Gateelektrode.
- Figur 4: zeigt einen Schnitt durch das Substrat nach Bildung dotierter Polysiliziumstrukturen durch selektive Epitaxie und Bildung von Source-/Draingebieten.

An der Oberfläche eines Substrats 1, zum Beispiel einer monokristallinen Siliziumscheibe oder der monokristallinen Siliziumschicht eines SOI-Substrats wird eine Isolationsstruktur 2 gebildet. Die Isolationsstruktur 2 umgibt ein aktives Gebiet 3 ringförmig. Die Isolationsstruktur 2 wird zum Beispiel durch lokale Oxidation in einem LOCOS-Prozeß oder durch Ätzen und Auffüllen eines Grabens in einem Shallow Trench Isolationsprozeß gebildet.

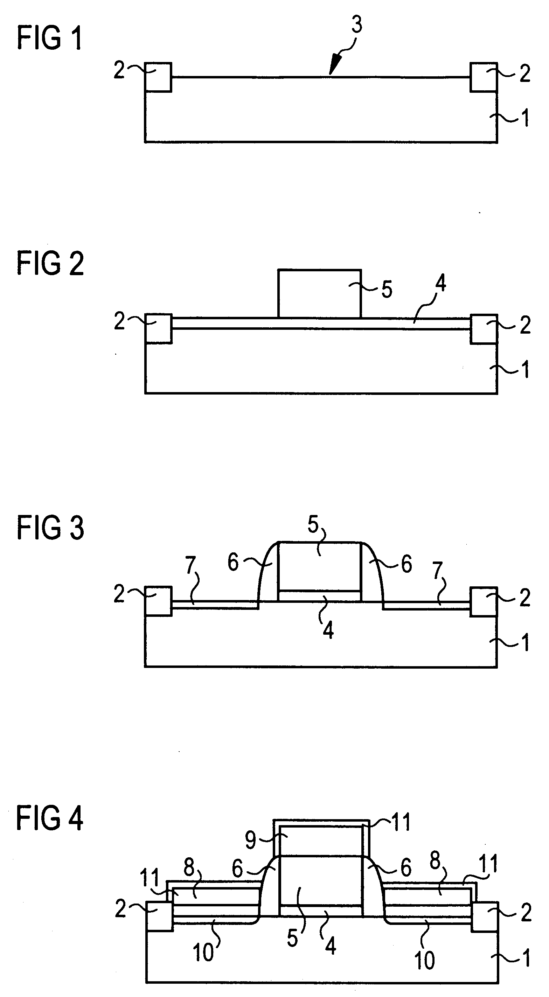

Nach einer Implantation zur Einstellung einer Kanaldotierung zum Beispiel mit As, B oder P mit einer Energie von 10 bis 100 keV und einer Dosis von 10¹² bis 10¹⁴ cm⁻² wird durch thermische Oxidation ein Gatedielektrikum 4 gebildet (siehe Figur 2). Das Gatedielektrikum 4 wird in einer Dicke von zum Beispiel 3 bis 10 nm gebildet. Anschließend wird durch Abscheidung und Strukturierung einer n⁺-dotierten Polysiliziumschicht eine Gateelektrode 5 gebildet.

Anschließend wird durch konformes Abscheiden einer SiO₂-Schicht und anisotropes Trockenätzen Spacer 6 an den Seitenwänden der Gateelektrode 5 gebildet. Die Trockenätzung wird zum Beispiel mit CHF₃/CF₄ durchgeführt. Durch die Trockenätzung werden in der freigelegten Oberfläche des Halbleitersubstrats 1 Gebiete mit Kristalldefekten 7 gebildet (siehe Figur 3).

Anschließend wird eine selektive Epitaxie unter Verwendung eines H₂, HCl, SiH₂Cl₂ enthaltenden Prozeßgases durchgeführt. Dabei wachsen auf der freiliegenden Oberfläche des Halbleitersubstrats 1 Polysiliziumstrukturen auf. Gleichzeitig wächst auf der freiliegenden Oberfläche der Gateelektrode 5 eine Deckschicht 9 aus Polysilizium auf (siehe Figur 4). Da an der Oberfläche des Halbleitersubstrats 1 die Gebiete mit Kristalldefekten 7 angeordnet sind, wächst bei der selektiven Epitaxie kein monokristallines Silizium auf, es bilden sich vielmehr die besagten Polysiliziumstrukturen 8. Die selektive Epitaxie wird vorzugsweise im Temperaturbereich zwischen 700°C und 900°C und im Druckbereich zwischen 1 und 700 Torr durchgeführt unter Verwendung eines H₂, HCl, SiH₂Cl₂ enthaltenden Prozeßgases.

Anschließend werden die Polysiliziumstrukturen 8 durch Implantation dotiert. Gleichzeitig wird die Deckschicht 9 dotiert. Die Implantation erfolgt zum Beispiel mit B, As oder P bei einer Energie von 5 bis 100 keV und einer Dosis von 10¹⁵ bis 10²¹ cm⁻².

In einem Temperschritt zum Beispiel bei 800 bis 1100°C, 5 bis 1000 Sekunden erfolgt eine Ausdiffusion von Dotierstoff aus den dotierten Polysiliziumstrukturen 8 in das darunterliegende Halbleitersubstrat 1. Dabei werden flache Source-/Draingebiete 9 gebildet. Gleichzeitig heilen die Kristalldefekte, die bei der Trockenätzung entstanden sind, aus.

Vor der Implantation zur Dotierung der Polysiliziumstrukturen 8 ist es vorteilhaft, eine thermische Oxidation bei zum Beispiel 700 bis 1100°C durchzuführen, bei der an der Oberfläche der Polysiliziumstrukturen 8 und der Deckschicht 9 eine SiO₂-Schicht 11 gebildet wird. Die SiO₂-Schicht 11 wirkt bei der nachfolgenden Implantation als Streuoxid. Ferner wird durch die thermische Oxidation ein zwischen den Spacern 6 und der Polysiliziumstruktur 8 gebildeter Spalt aufgefüllt.

Durch Aufbringen einer Passivierungsschicht, Öffnen von Kontaktlöchern zu den Source-/Draingebieten und der Gateelektrode und Bildung von Metallkontakten wird der MOS-Transistor in bekannter Weise fertiggestellt (nicht im einzelnen dargestellt).

## Patentansprüche

1. MOS-Transistor,
- bei dem in einem Halbleitersubstrat (1) zwei Source-/Draingebiete (10) und ein dazwischenliegendes Kanalgebiet angeordnet sind,
- bei dem an der Oberfläche des Kanalgebiets ein Gatedielektrikum (4) und eine Gateelektrode (5) angeordnet sind,
- bei dem an der Oberfläche der Source-/Draingebiete (10) jeweils eine epitaktisch gewachsene, dotierte Polysiliziumstruktur (8) angeordnet ist, die von demselben Leitfähigkeitstyp wie die Source-/Draingebiete (10) dotiert ist.

2. Verfahren zur Herstellung eines MOS-Transistors,
- bei dem an einer Oberfläche eines Halbleitersubstrats (1) ein Gatedielektrikum (4) und eine Gateelektrode (5) gebildet werden,
- bei dem eine isolierende Schicht mit im wesentlichen konformer Kantenbedeckung abgeschieden wird,
- bei dem durch anisotropes Rückätzen der isolierenden Schicht an den Seitenwänden der Gateelektrode (5) Spacer (6) gebildet werden und die Oberfläche des Halbleitersubstrats freigelegt und geschädigt wird,
- bei dem unter Verwendung von selektiver Epitaxie auf der freiliegenden Oberfläche des Halbleitersubstrats (1) dotierte Polysiliziumstrukturen (8) erzeugt werden,
- bei dem durch Ausdiffusion aus den dotierten Polysiliziumstrukturen (8) Source-/Draingebiete (10) gebildet werden.

3. Verfahren nach Anspruch 2,
bei dem nach der selektiven Epitaxie eine thermische Oxidation durchgeführt wird.

4. Verfahren nach Anspruch 2 oder 3,
bei dem die dotierten Polysiliziumstrukturen (8) durch Implantation dotiert werden.

5. Verfahren nach einem der Ansprüche 2 bis 4,
- bei dem in der Oberfläche des Halbleitersubstrats (1) eine Isolationsstruktur (2) gebildet wird, die ein aktives Gebiet (3) für den MOS-Transistor definiert,
- bei dem die Gateelektrode (5) so strukturiert wird, daß sie streifenförmig über dem aktiven Gebiet (3) verläuft und das aktive Gebiet (3) in zwei Teilgebiete unterteilt.

6. Verfahren nach einem der Ansprüche 2 bis 5,
- bei dem die isolierende Schicht SiO₂ aufweist,
- bei dem das anisotrope Rückätzen mit CHF₃/CF₄ erfolgt.

7. Verfahren nach einem der Ansprüche 2 bis 6,
bei dem die selektive Epitaxie unter Verwendung eines H₂, HCl, SiH₂Cl₂ enthaltenden Prozeßgases im Temperaturbereich von 700 bis 900°C und im Druckbereich von 1 bis 700 Torr durchgeführt wird.
